Europäisches Patentamt

European Patent Office

Office européen des brevets

(19)

(11) Numéro de publication : **0 013 644**
**B1**

(12) **FASCICULE DE BREVET EUROPÉEN**

(45) Date de publication du fascicule du brevet :
13.10.82

(51) Int. Cl.³ : **C 23 C 11/16**

(21) Numéro de dépôt : **80400017.2**

(22) Date de dépôt : **08.01.80**

(54) **Perfectionnement à la nitruration ionique des corps creux allongés, en aciers.**

(30) Priorité : 10.01.79 FR 7900511

(43) Date de publication de la demande :
23.07.80 (Bulletin 80/15)

(45) Mention de la délivrance du brevet :
13.10.82 Bulletin 82/41

(84) Etats contractants désignés :
BE DE GB IT LU NL

(56) Documents cités :
DE A 1 690 663
DE C 1 281 771
FR A 1 575 982
FR A 2 110 290

(73) Titulaire : **CREUSOT-LOIRE**
**42 rue d'Anjou**
**F-75008 Paris (FR)**

(72) Inventeur : **Leveque, Robert**
**40 rue du Champ de Mars**
**F-42700 - Firminy (FR)**

(74) Mandataire : **Leroy, Pierre et al**
**CREUSOT-LOIRE 15 rue Pasquier**
**F-75383 Paris Cedex 08 (FR)**

Imprimerie Jouve, 18, rue St-Denis, 75001 Paris, France

## Perfectionnement à la nitruration ionique des corps creux allongés, en aciers

La présente invention concerne la nitruration ionique des corps creux allongés, en aciers.

Il est connu de réaliser une telle nitruration ionique au moyen d'une anode creuse cylindrique, de même longueur que celle du corps creux à nitrurer, munie de petits orifices disposés en quinconce sur toute sa longueur, et que l'on enfile dans ledit corps creux, en la faisant parcourir par un mélange gazeux contenant notamment de l'azote et de l'hydrogène.

Les décharges électriques créées par différence de potentiel entre l'anode et le corps creux fonctionnant comme une cathode, sous pression gazeuse réduite à quelques millibars, provoquent la formation, à proximité de la surface interne du corps creux, d'une zone d'effluves dans laquelle les ions gazeux sont formés et accélérés, entraînant ainsi l'échauffement dudit corps creux.

Le traitement s'effectue dans une enceinte fermée reliée à une pompe à vide et la pression partielle de quelques millibars est obtenue par réglage du débit du mélange gazeux et du groupe de pompage. Les atmosphères utilisées sont constituées essentiellement par des mélanges gazeux d'azote et d'hydrogène ; certaines correspondent au cracking de l'ammoniac avec 25 % d'azote et 75 % d'hydrogène en volume.

Un tel système connu (voir par exemple DE-A-1 690 663) fonctionne de façon satisfaisante pour les corps creux dont la paroi interne est un cylindre de même diamètre sur toute la longueur.

Par contre, il est loin de donner satisfaction pour les corps creux dont le diamètre intérieur varie. En effet, avec un même diamètre d'anode centrale, les caractéristiques des couches nitrurées (épaisseur et dureté) peuvent varier de manière importante si le diamètre intérieur du corps creux évolue sur sa longueur.

Le but de la présente invention est de réaliser une nitruration homogène sur toute la longueur d'un corps de diamètre intérieur variable, par des perfectionnements aux dispositifs connus et aux méthodes connues de nitruration ionique.

A cet effet, la présente invention a d'abord pour objet un dispositif de nitruration ionique de corps creux allongés à diamètre intérieur variable, utilisant une anode centrale creuse amenant le mélange gazeux de nitruration, percée d'orifices, disposés en quinconce, sur toute sa longueur, et introduite dans ledit corps creux placé dans une enceinte soumise à une pression réduite et contrôlée, ce dispositif étant caractérisé en ce que le profil de ladite anode épouse à distance constante le profil intérieur dudit corps creux, cette distance constante étant comprise entre 3 millimètres et 9 millimètres, et de préférence entre 6 et 8 millimètres.

L'anode centrale peut être utilement rendue bien coaxiale au corps creux en utilisant des dispositifs assurant à la fois le centrage et l'isolation en prenant appui sur le corps creux.

Suivant une caractéristique préférentielle de la présente invention, les orifices de sortie du mélange gazeux tout le long de l'anode, en face de la paroi intérieure du corps creux, sont de diamètre croissant dans le sens de l'écoulement du mélange gazeux, de préférence depuis 1 millimètre à l'entrée de l'anode jusqu'à 2,5 millimètres à la sortie de celle-ci.

Suivant une autre caractéristique préférentielle de la présente invention, l'anode dépasse l'extrémité du corps creux du côté de la sortie du mélange gazeux, et elle présente, à une distance de cette extrémité comprise entre 20 et 50 millimètres, des orifices supplémentaires d'évacuation du mélange gazeux, d'un diamètre compris entre 3 et 5 millimètres. Ces orifices supplémentaires peuvent être avantageusement au nombre de trois et disposés à 120° l'un de l'autre sur une même section transversale de l'anode.

Suivant une autre caractéristique préférentielle de la présente invention, le corps creux est muni sur sa face externe de deux thermocouples disposés, le premier sur la partie la plus épaisse dudit corps creux, et le deuxième sur sa partie la plus mince, lesdits thermocouples étant mis en place et guidés par des dispositifs d'isolation. A chaque instant, le réglage optimal des paramètres électriques, de la pression partielle régnant dans l'enceinte et de l'écoulement gazeux est obtenu si les températures mesurées à cet instant par les deux thermocouples sont les mêmes.

Le dispositif ci-dessus est destiné à la mise en œuvre de deux méthodes de nitruration ionique de corps creux allongés à diamètre intérieur variable qui font également partie de l'invention.

La première de ces deux méthodes utilise en permanence un mélange gazeux d'azote et d'hydrogène dont la teneur en azote est comprise entre 10 % et 15 % en volume ; elle comprend cinq phases distinctes successives, dans l'ordre suivant :

a) Une mise sous vide de l'enceinte contenant les corps creux et leur anode.

b) Un décapage sous pression très réduite, inférieure à 0,8 millibar, avec une légère montée en température, inférieure à 100 °C.

c) Une montée en température jusqu'à un maximum, accompagnée d'une montée progressive en pression jusqu'à atteindre la pression de traitement, comprise entre 2,5 et 10 millibars.

d) Un maintien à température constante maximale, sous ladite pression de traitement.

e) Un refroidissement final sous vide, cette première méthode étant caractérisée en ce que la température constante maximale de la phase (d) est comprise entre 510° et 540 °C, et que la durée de cette phase (d) est comprise entre 25 et 70 heures.

La deuxième des deux méthodes selon l'invention est destinée à détensionner, avant nitruration, les contraintes du corps creux à traiter, par exemple les contraintes dues à l'écrouissage par usinage ou par déformation à froid. Elle est caractérisée par la succession des sept phases suivantes :

a) Une mise sous vide de l'enceinte contenant les corps creux et leur anode.

b) Un décapage sous pression très réduite, inférieure à 0,8 millibar, accompagné d'une légère montée en température, inférieure à 100 °C, avec utilisation d'un mélange gazeux d'azote et d'hydrogène contenant entre 1 % et 4 % d'azote en volume.

c) Une montée en température jusqu'à 430° et 540 °C, accompagnée d'une montée progressive en pression, jusqu'à la pression de traitement de 2,5 à 10 millibars, et avec le même mélange gazeux que pendant le décapage (b).

d) Un maintien à température constante comprise entre 430 °C et 540 °C pendant une durée comprise entre une heure et six heures, et de préférence voisine de 4 heures, toujours avec le mélange gazeux décrit ci-dessus en (b), mais sous une pression comprise entre 2,5 et 10 millibars.

e) Une nouvelle montée en température, depuis 430 °C à 540 °C jusqu'à 460 °C à 570 °C, avec un mélange gazeux d'azote et d'hydrogène contenant entre 10 % et 15 % d'azote en volume.

f) Un maintien à température constante maximale comprise entre 460 °C et 570 °C, pendant une durée de 25 à 70 heures, et sous la pression de traitement de 2,5 à 10 millibars, avec le mélange gazeux décrit ci-dessus en (e).

g) Un refroidissement final sous vide.

Comme on le comprend, l'un des principaux avantages du dispositif perfectionné selon l'invention est que l'intervalle existant entre l'anode et le corps creux formant cathode est exactement le même sur toute la longueur du corps creux, quelles que soient les variations de diamètre intérieur de celui-ci. Il en résulte une forte amélioration de la qualité et de la régularité de la nituration des corps creux de diamètre variable sur leur longueur.

Un autre avantage essentiel du dispositif selon l'invention est que cet intervalle est fixé à une valeur comprise entre 3 et 9 millimètres, et de préférence entre 6 et 8 millimètres, alors que l'épaisseur de la zone d'effluves qui entoure la surface intérieure du corps creux est comprise entre 2 et 6 millimètres. Il en résulte que la distance entre l'anode centrale et le corps creux est un peu supérieure à l'épaisseur de la zone d'effluves où les ions sont accélérés vers la surface intérieure du corps creux, ce qui permet d'éviter tout échauffement parasite de ce dernier.

Un avantage des orifices de l'anode à section croissante dans le sens de l'écoulement, et de la présence des orifices supplémentaires d'évacuation, est de permettre de très bien contrôler l'écoulement gazeux tout le long du corps creux.

L'avantage des deux thermocouples est de permettre de maintenir à chaque instant une égale température sur la face externe de la partie la plus épaisse et sur la face externe de la partie la plus mince du corps creux. En cas de légère différence, il suffit de jouer sur le débit du mélange gazeux ou sur les paramètres électriques pour rétablir l'égalité des deux températures mesurées.

En ce qui concerne les deux méthodes de nituration ionique selon l'invention, la première s'applique à des corps creux qui n'ont supporté que peu de contraintes internes avant nituration, tandis que la deuxième plus complexe, opère un détensionnement à un niveau thermique intermédiaire, avant d'effectuer la nituration ionique proprement dite, pour les corps creux qui conservent des contraintes internes, par exemple en provenance d'un écrouissage sévère dû à l'usinage de leur face intérieure, ou à un procédé de mise en forme à froid.

Afin de bien faire comprendre l'invention, on va décrire ci-après, à titre d'exemple non limitatif, un mode de réalisation d'un dispositif selon l'invention, en décrivant ensuite l'application, au moyen de ce dispositif, de chacune des deux méthodes de nituration ionique définies précédemment.

La figure 1 représente une coupe verticale du corps creux à nitrurer et de son anode centrale.

La figure 2 représente une coupe verticale de l'enceinte de nituration contenant le corps creux à nitrurer, son anode et le dispositif de suspension de ceux-ci.

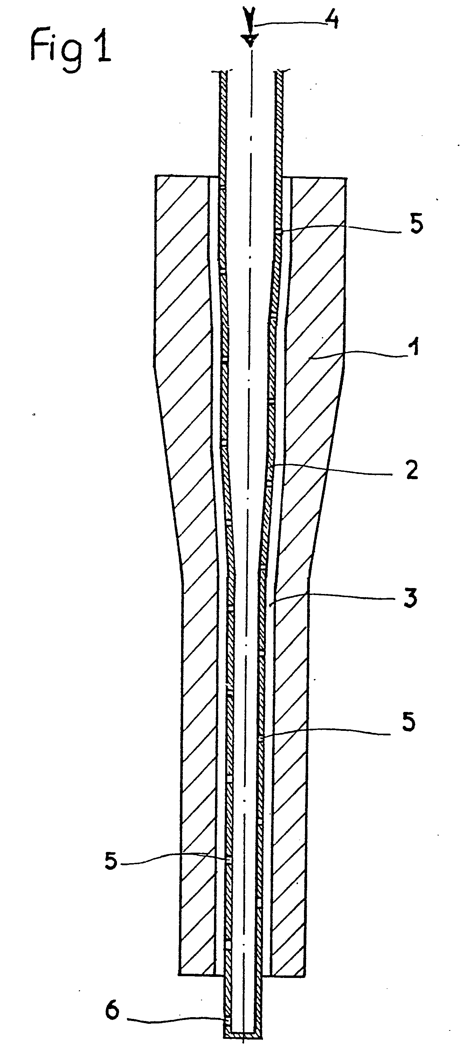

Sur la figure 1, le corps creux à nitrurer, dont le diamètre intérieur varie sur la longueur, est représenté en 1. L'anode centrale 2, creuse, permet d'amener le mélange gazeux réactif à l'intérieur dudit corps creux 1. Son profil épouse à distance le profil de l'intérieur du corps creux. La distance entre l'anode centrale et la surface interne du corps creux, indiquée en 3, est constante d'une extrémité à l'autre du corps creux et toujours comprise entre 3 et 9 millimètres, de préférence entre 6 et 8 millimètres. Dans le présent exemple, elle est de 7 millimètres. L'arrivée du mélange gazeux réactif à l'intérieur du corps creux est représentée en 4. Sa distribution est assurée au moyen d'orifices calibrés disposés en quinconce représentés en 5 et dont le diamètre varie d'une extrémité à l'autre du corps creux, depuis 1 millimètre à l'entrée jusqu'à 2,5 millimètres à la sortie. Les orifices supplémentaires d'évacuation du mélange gazeux, représentés en 6, sont à une distance de l'extrémité du corps creux de 40 millimètres. ils sont au nombre de trois, disposés à 120° sur une même section transversale de l'anode et leur diamètre est de 4 millimètres.

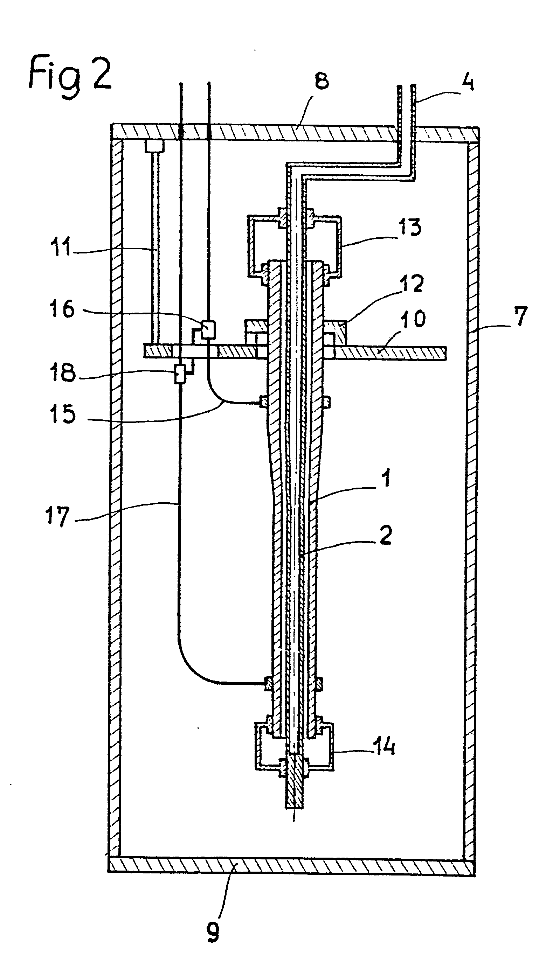

Sur la figure 2 est représenté le montage du corps creux et de son anode centrale à l'intérieur de l'enceinte de nituration. Cette enceinte est constituée par l'ensemble de la virole 7, de la platine supérieure 8 et de la platine inférieure 9. Le corps creux 1 dont l'intérieur est à nitrurer est suspendu dans l'enceinte de nituration à l'aide d'un plateau 10 rendu solidaire de la platine supérieure 8 par plusieurs colonnes métalliques isolées de la platine 8 telles que 11. La pièce à traiter 1 est maintenue sur le plateau de suspension 10 à l'aide du dispositif de centrage 12. L'anode centrale 2 amenant le mélange gazeux réactif est centrée sur le corps creux 1 et isolée de ce dernier au moyen de deux dispositifs prenant appui sur le corps creux, le premier, représenté en 13 sur la partie supérieure de ce dernier et le deuxième représenté en 14 sur sa partie inférieure. Les deux thermocouples qui assurent le réglage optimal des paramètres électriques, de la pression partielle régnant dans l'enceinte et de l'écoulement gazeux, sont représentés, avec leur dispositif de guidage et d'isolation au travers du plateau de suspension 10, en 15 et 16 pour le thermocouple situé dans la partie la plus massive du corps creux, en 17 et 18 pour le thermocouple situé dans la partie la moins massive de ce dernier. .

Nous donnons ci-dessous à titre non limitatif deux exemples de réalisation de traitements de nitruration ionique à l'intérieur d'un corps creux au moyen du dispositif précédemment décrit, lorsque ce corps creux est en acier du type 35 CDV 12 ; le premier est relatif à un corps creux ayant peu de contraintes internes avant nitruration ; le second est relatif à un corps creux ayant un niveau élevé de contraintes internes avant nitruration, par suite d'une opération sévère d'usinage de sa surface intérieure ou d'une opération de mise en forme à froid.

Dans le premier traitement, l'atmosphère réactive utilisée est un mélange gazeux azote-hydrogène comprenant 13 % en volume d'azote. L'opération comprend cinq phases distinctes :

— une mise sous vide de l'enceinte contenant les corps creux et leur anode,

— une mise en condition de la surface cathodique interne du corps creux par décapage sous pression réduite, inférieure à 0,8 millibar, accompagnée d'une légère montée en température, inférieure à 100 °C en un temps voisin de 2 heures,

— une montée en température, accompagnée d'une montée progressive en pression, jusqu'à atteindre la pression de traitement de 4,5 millibars, cette montée en température étant assurée en un temps voisin de 3 heures,

— un maintien en température entre 520 et 525 °C pendant une durée voisine de 35 heures, assurée par une tension entre électrodes voisine de 520 volts,

— un refroidissement final sous vide.

Dans le deuxième traitement, la première phase thermique est destinée à détensionner avant nitruration, les contraintes du corps creux à traiter. Ce traitement, plus complexe comprend sept phases distinctes :

— une mise sous vide de l'enceinte contenant les corps creux et leur anode,

— une mise en condition de la surface cathodique interne du corps creux par décapage sous pression réduite, inférieure à 0,8 millibar, accompagné d'une légère montée en température, inférieure à 100 °C, avec un mélange gazeux d'azote et d'hydrogène contenant de 2 à 3 % en volume d'azote, en un temps voisin de 2 heures,

— une montée en température jusqu'à 490° à 500 °C, accompagnée d'une montée progressive en pression jusqu'à la pression de traitement de 4,5 millibars en un temps voisin de 3 heures,

— un maintien d'une durée de 3 heures à la température de 490 ° à 500 °C avec utilisation du mélange gazeux décrit ci-dessus, assuré par une tension entre électrodes voisine de 500 volts,

— une montée à la température de traitement entre 520 et 525 °C avec utilisation d'un mélange gazeux azote-hydrogène contenant 13 % en volume d'hydrogène en un temps voisin de 30 minutes,

— un maintien en température entre 520 et 525 °C pendant une durée voisine de 35 heures, assurée par une tension entre électrodes voisine de 520 volts,

— un refroidissement final sous vide.

Les caractéristiques des couches nitrurées obtenues à l'intérieur des corps creux après les deux types de traitements sont les suivantes : dureté Vickers sous 100 kilogrammes/force comprise entre 500 et 700 ; profondeur de nitruration comprise entre 350 et 400 microns ; profondeur de nitruration caractérisée par une microdureté Vickers sous 0,1 kilogramme/force supérieure à 600 comprise entre 250 et 300 microns.

Il est entendu que l'on peut, sans sortir du cadre de l'invention, imaginer des variantes et perfectionnements de détails, de même qu'envisager l'emploi de moyens équivalents.

La présente invention s'applique spécialement bien à la nitruration des tubes pour armement.

**Revendications**

1. Méthode de nitruration ionique d'un corps creux allongé à diamètre intérieur variable, en acier, utilisant une anode centrale creuse amenant le mélange gazeux de nitruration, percée d'orifices, et introduite dans ledit corps creux placé dans une enceinte soumise à une pression réduite et contrôlée, cette méthode étant utilisable pour des corps creux soumis à des contraintes internes, étant destinée à détensionner, juste avant nitruration, les contraintes des corps creux à traiter, et étant caractérisée par la succession des sept phases suivantes :

a) une mise sous vide de l'enceinte contenant le ou les corps creux et son ou leurs anodes ;

b) un décapage sous pression très réduite, inférieure à 0,8 millibar, accompagnée d'une légère montée en température, inférieure à 100 °C, avec utilisation d'un mélange gazeux d'azote et d'hydrogène contenant entre 1 % et 4 % d'azote en volume ;

c) une montée en température jusqu'à 430 °C à 540 °C, accompagnée d'une montée progressive de pression jusqu'à la pression de traitement de 2,5 à 10 millibars et avec le même mélange gazeux que pendant le décapage (b) ;

d) un maintien à température constante comprise entre 430 °C et 540 °C pendant une durée comprise entre une heure et six heures, et de préférence voisine de quatre heures, toujours avec le mélange gazeux décrit ci-dessus en (b) sous une pression comprise entre 2,5 et 10 millibars ;

e) une nouvelle montée en température, depuis 430 °C-540 °C jusqu'à 460 °C-570 °C, avec un mélange gazeux d'azote et d'hydrogène contenant entre 10 % et 15 % d'azote en volume ;

f) un maintien à température constante maximale de 460° à 570 °C pendant une durée de 25 à 70 heures, et sous la pression de traitement de 2,5 à 10 millibars, avec le mélange gazeux décrit ci-dessus en (e) ;

g) un refroidissement final sous vide.

2. Méthode de nitruration ionique selon la revendication 1, utilisable pour des corps creux ne subissant que peu de contraintes internes, et caractérisée en ce que les phases (d) (e) (f) mentionnées ci-dessus sont remplacées par une phase unique de maintien à une température constante maximale comprise entre 510 °C et 540 °C, pendant une durée comprise entre 24 et 70 heures, sous la pression de traitement de 2,5 à 10 millibars, avec un mélange gazeux d'azote et d'hydrogène contenant entre 10 % et 15 % d'azote en volume.

3. Dispositif de nitruration ionique de corps creux allongés, en aciers, à diamètre intérieur variable, pour la mise en œuvre de l'une ou l'autre des méthodes de nitruration ionique selon les revendications 1 et 2, ce dispositif étant caractérisé en ce que le profil de l'anode (2) épouse à distance constante le profil intérieur dudit corps creux (1), cette distance constante étant comprise entre 3 millimètres et 9 millimètres.

4. Dispositif selon la revendication 3, caractérisé en ce que l'anode centrale (2) est rendue bien coaxiale au corps creux au moyen de dispositifs (13) (14) assurant à la fois le centrage et l'isolation, en prenant appui sur la pièce à traiter (1).

5. Dispositif selon l'une quelconque des revendications 3 et 4, caractérisé en ce que les orifices de sortie (5) du mélange gazeux tout le long de l'anode (2), en face de la paroi intérieure du corps creux (1), sont disposés en quinconce, et sont de diamètre croissant dans le sens de l'écoulement du mélange gazeux, de préférence depuis 1 millimètre à l'entrée de l'anode jusqu'à 2,5 millimètres à la sortie de celle-ci.

6. Dispositif selon l'une quelconque des revendications 3 à 5, caractérisé en ce que l'anode (2), dépasse l'extrémité du corps creux (1) du côté de la sortie du mélange gazeux, et qu'elle présente, à une distance de cette extrémité comprise entre 20 et 50 millimètres, des orifices supplémentaires (6) d'évacuation du mélange gazeux, d'un diamètre compris entre 3 et 5 millimètres.

7. Dispositif selon la revendication 6, caractérisé en ce que ces orifices supplémentaires (6), sont au nombre de 3 et disposés à 120° l'un de l'autre sur une même section transversale de l'anode.

8. Dispositif selon l'une quelconque des revendications 3 à 7, caractérisé en ce que le corps creux (1) est muni sur sa face externe de deux thermocouples disposés, le premier (15-16) sur la partie la plus épaisse dudit corps creux, et le deuxième (17-18) sur sa partie la plus mince, lesdits thermocouples étant mis en place et guidés par des dispositifs d'isolation.

9. Méthode de réglage du dispositif selon la revendication 8, caractérisée en ce que l'on règle les paramètres électriques et l'écoulement gazeux de façon à ce que les indications de température des deux thermocouples soient égales entre elles à chaque instant.

**Claims**

1. Method for ionic nitriding of an elongate hollow body of steel with variable internal diameter, using a hollow central anode conveying the gaseous nitriding mixture, perforated with orifices, and introduced into the said hollow body which is located in an enclosure subjected to a reduced and controlled pressure, this method being usable for hollow bodies subject to internal stresses, being intended to relieve, just before nitriding, the stresses in the hollow bodies to be treated, and being characterised by the following seven stages in succession :

a) setting the enclosure containing the hollow body or bodies and its or their anodes under vacuum ;

b) pickling under very reduced pressure, lower than 0.8 millibars, accompanied by a slight rise in temperature, less than 100 °C, with the use of a gaseous mixture of nitrogen and hydrogen containing between 1 % and 4 % of nitrogen by volume ;

c) raising the temperature to 430 °C to 540 °C, accompanied by a progressive rise in pressure to the process pressure of 2.5 to 10 millibars and with the same gaseous mixture as during pickling (b) ;

d) maintenance at a constant temperature of between 430 °C and 540 °C for a duration of between one hour and six hours, with the gaseous mixture described hereinbefore at (b) always under a pressure of between 2.5 and 10 millibars ;

e) further raising of the temperature, from 430 °C-540 °C to 460 °C-570 °C, with a gaseous mixture of nitrogen and hydrogen containing between 10 % and 15 % of nitrogen by volume ;

f) maintenance at a maximum constant temperature of 460 °C to 570 °C for a duration of 25 to 70 hours, and under the process pressure of 2.5 to 10 millibars, with the gaseous mixture described hereinbefore at (e) ;

g) final cooling under vacuum.

2. Method of ionic nitriding according to Claim 1, which can be used for hollow bodies subject to only slight internal stress, and characterised in that the stages (d) (e) (f) referred to hereinbefore are replaced by a single stage of maintenance at a maximum constant temperature of between 510 °C and 540 °C, for a duration of between 24 and 70 hours, under the process pressure of 2.5 to 10 millibars, with a gaseous mixture of nitrogen and hydrogen containing between 10 % and 15 % of nitrogen by volume.

3. Apparatus for ionic nitriding of elongate hollow bodies of steel, with variable internal diameter, for carrying out one or other of the methods of ionic nitriding according to Claims 1 and 2, this apparatus being characterised in that the outline of the anode (2) corresponds at a constant distance to the internal outline of the said hollow body (1), this constant distance being between 3 millimetres and 9 millimetres.

4. Apparatus according to Claim 3, characterised in that the central anode (2) is made completely coaxial with the hollow body by means of devices (13) (14) ensuring both centring and insulation, while being supported by the piece (1) to be treated.

5. Apparatus according to either of Claims 3 and 4, characterised in that the outlet orifices (5) for the gaseous mixture along the whole length of the anode (2) facing the internal wall of the hollow body (1), are arranged quincuncially, and are of increasing diameter in the direction of flow of the gaseous mixture, preferably from 1 millimetre at the inlet of the anode to 2.5 millimetres at the outlet thereof.

6. Apparatus according to any one of Claims 3 to 5, characterised in that the anode (2) extends beyond the end of the hollow body (1) at the outlet side for the gaseous mixture, and that it presents, at a distance from this end of between 20 and 50 millimetres, additional orifices (6) for outflow of the gaseous mixture, of a diameter of between 3 and 5 millimetres.

7. Apparatus according to Claim 6, characterised in that there are three of these additional orifices (6) which are arranged at 120° from one another in the same cross-section of the anode.

8. Apparatus according to any one of Claims 3 to 7, characterised in that the hollow body (1) is provided on its external face with two thermocouples arranged with the first (15-16) on the thickest part of the said hollow body and the second (17-18) on the thinnest part thereof, the said thermocouples being located and guided by insulating devices.

9. Method of regulating the apparatus according to Claim 8, characterised in that the electrical parameters and the gaseous flow are regulated so that the temperature indications of the two thermocouples are equal to one another at every instant.

### Ansprüche

1. Verfahren zum Plasmanitrieren von einem langgestreckten Hohlkörper aus Stahl mit veränderlichem Innendurchmesser unter Anwendung einer zum Zuführen der gasförmigen Nitriermischung mit Öffnungen versehenen zentralen Hohlanode, die in den in einer mit vermindertem Druck zwangsgeregelten Kammer angeordneten Hohlkörper eingesetzt wird, wobei dieses Verfahren für Innenspannungen aufweisende Hohlkörper zum Einsatz kommt, diese bei den zu behandelnden Hohlkörpern kurz vor dem Nitrieren entspannt und durch die nachstehenden aufeinanderfolgenden sieben Vorgänge gekennzeichnet ist :

a) Herstellung von Unterdruck in der den oder die Hohlkörper mit dessen oder deren Anode(n) enthaltende(n) Kammer ;

b) Beizen bei sehr geringem Druck unter 0,8 Millibar mit einem leichten Temperaturanstieg unter 100 °C unter Anwendung einer gasförmigen Stickstoff- und Wasserstoffmischung mit 1 % bis 4 % Vol. Stickstoff ;

c) Temperaturanstieg auf 430 °C bis 540 °C mit einem stufenlosen Druckanstieg bis zum Behandlungsdruck von 2,5 bis 10 Millibar unter Einsatz derselben wie für das Beizen b) angewandte gasförmigen Mischung ;

d) Halten bei konstanter Temperatur zwischen 430 °C und 540 °C während ein bis sechs Stunden, vorzugsweise etwa vier Stunden, weiterhin mit der unter b) vorher beschriebenen gasförmigen Mischung bei einem Druck von 2,5 bis 10 Millibar ;

e) Erneuter Temperaturanstieg von 430 °C-540 °C bis auf 460 °C-570 °C unter Anwendung einer Stickstoff- und Wasserstoffmischung mit einem Stickstoffgehalt von 10 % bis 15 % Vol.

f) Halten bei konstanter Höchsttemperatur von 460 °C bis 570 °C während 25 bis 70 Stunden und bei dem Behandlungsdruck von 2,5 bis 10 Millibar unter Einsatz der unter e) beschriebenen gasförmigen Mischung ;

g) Endabkühlung unter Vakuum.

2. Verfahren zum Plasmanitrieren gemäß Anspruch 1, das für Hohlkörper mit nur wenig Innenspannungen einsetzbar ist, dadurch gekennzeichnet, daß die oben aufgeführten Vorgänge d), e), f) durch einen einzigen Haltevorgang bei einer konstanten Höchsttemperatur von 510 °C bis 540 °C während 24 bis 70 Stunden bei einem Behandlungsdruck von 2,5 bis 10 Millibar unter Anwendung einer gasförmigen Stickstoff- und Wasserstoffmischung mit 10 % bis 15 % Vol. Stickstoff ersetzt werden.

3. Vorrichtung zum Plasmanitrieren von langgestreckten Hohlkörpern aus Stahl mit veränderlichem Innendurchmesser zur Anwendung der jeweiligen Plasmanitrierverfahren gemäß den Ansprüchen 1 und 2, dadurch gekennzeichnet, daß bei einem konstanten Abstand von 3 bis 9 Millimeter der Anodenaussenprofil (2) der Hohlkörperinnenausbildung (1) angepasst ist.

4. Vorrichtung nach Anspruch 3, dadurch gekennzeichnet, daß mittels auf dem zu behandelnden Werkstück (1) sich abstützenden Zentrier- und Isoliervorrichtungen (13, 14) die zentrale Anode (2) gegenüber dem Hohlkörper koaxial angeordnet wird.

5. Vorrichtung nach einem der Ansprüche 3 und 4, dadurch gekennzeichnet, daß die Ausgangsöffnungen (5) der gasförmigen Mischung entlang der Anode (2) gegenüber der Hohlkörperinnenwand (1) versetzt angeordnet sind und deren Durchmesser in Strömungsrichtung der gasförmigen Mischung, vorzugsweise von 1 Millimeter am Anodeneingang bis 2,5 Millimeter am Anodenausgang, zunehmen.

6. Vorrichtung nach einem der Ansprüche 3 bis 5, dadurch gekennzeichnet, daß an der Ausgangsseite der gasförmigen Mischung die Anode (2) das Hohlkörperende (1) überragt, und daß diese zum Abführen der gasförmigen Mischung in 20 bis 50 Millimeter von diesem Ende zusätzliche Öffnungen (6) mit 3 bis 5 Millimeter Durchmesser aufweist.

7. Vorrichtung nach Anspruch 6, dadurch gekennzeichnet, daß die in der Anzahl 3 zusätzlichen Öffnungen um 120° von einander in demselben Querschnitt der Anode angeordnet sind.

8. Vorrichtung nach einem der Ansprüche 3 bis 7, dadurch gekennzeichnet, daß der Hohlkörper (1) auf seiner Aussenseite zwei Thermoelemente aufweist, wobei das erste (15, 16) an der stärksten und das andere (17, 18) an der dünnsten Hohlkörperwand angeordnet sind und über isoliervorrichtungen geführt und eingesetzt werden.

9. Verfahren zur Regelung der Vorrichtung gemäß Anspruch 8, dadurch gekennzeichnet, daß die elektrischen Parameter und die gasförmige Strömung so eingestellt werden, daß die Temperaturanzeige der beiden Thermoelemente stets gleich ist.

Fig 1

Fig 2